(19) Europäisches Patentamt

European Patent Office

Office européen des brevets

(11) **EP 1 110 316 B1**

(12) **EUROPÄISCHE PATENTSCHRIFT**

(45) Veröffentlichungstag und Bekanntmachung des Hinweises auf die Patenterteilung:
**14.04.2004  Patentblatt 2004/16**

(21) Anmeldenummer: 00947821.5

(22) Anmeldetag: **26.06.2000**

(51) Int Cl.⁷: $H03J\ 5/02$, $H03L\ 7/093$, $H03L\ 7/18$

(86) Internationale Anmeldenummer:
**PCT/DE2000/002066**

(87) Internationale Veröffentlichungsnummer:
**WO 2001/001573 (04.01.2001 Gazette 2001/01)**

(54) **PHASENREGELKREISSYSTEM**

PHASE-LOCKED LOOP SYSTEM

SYSTEME BOUCLE A VERROUILLAGE DE PHASE

(84) Benannte Vertragsstaaten:
**DE FR GB**

(30) Priorität: **25.06.1999  DE 19929178**

(43) Veröffentlichungstag der Anmeldung:
**27.06.2001  Patentblatt 2001/26**

(73) Patentinhaber: **Infineon Technologies AG**
**81669 München (DE)**

(72) Erfinder:
 • **MUSCHALLIK, Claus**
  **D-81369 München (DE)**
 • **PFLAUM, Bernd**
  **D-82008 Unterhaching (DE)**
 • **LANG, Heinz**
  **D-81539 München (DE)**

(74) Vertreter: **Epping, Hermann, Fischer**
**Patentanwaltsgesellschaft mbH**
**Ridlerstrasse 55**
**80339 München (DE)**

(56) Entgegenhaltungen:
**EP-A- 0 755 120       DE-A- 19 639 237**
**US-A- 5 339 050       US-A- 5 631 587**

 • **MUSCHALLIK C: "INFLUENCE OF RF OSCILLATORS ON AN OFDM SIGNAL" IEEE TRANSACTIONS ON CONSUMER ELECTRONICS,US,IEEE INC. NEW YORK, Bd. 41, Nr. 3, 1. August 1995 (1995-08-01), Seiten 592-603, XP000539512 ISSN: 0098-3063**

**Beschreibung**

Die Erfindung betrifft ein Phasenregelkreissystem zur Abstimmung einer Empfangsfrequenz eines Empfängers für digital und analog modulierte Empfangssignale, bei dem das Phasenrauschen minimiert wird.

Digitale Fernsehverteildienste (DVB: Digital Video Broadcasting) werden mittels eines OFDM-Multiplexverfahren übertragen. Der DVB-Übertragungsstandard umfaßt u.a. Verfahren der digitalen Modulation für Satelliten und Kabelfernsehverbreitung sowie für terrestrische Verbreitung, Systeme für Videotext und Programminformationen sowie für Signalverschlüsselung. Das OFDM-Multiplexverfahren eignet sich besonders gut für stark gestörte terrestrische Übertragung digitaler Rundfunksignale. Das OFDM-Multiplexverfahren ist besonders unempfindlich gegenüber Signalechos.

Da die Signalinformation bei dem OFDM-Multiplexverfahren in der Signalphase eincodiert ist, ist ein OFDM-Signalempfänger besonders empfindlich gegenüber Phasenrauschen bzw. Phasenschwankungen. Dies liegt insbesondere daran, daß der digitale Demodulator bei der OFDM-Demodulation nicht in der Lage ist, Phasenrauschen zu kompensieren, das oberhalb von Offset-Frequenzen von 10 bis 100 Hz auftritt. Herkömmliche Empfänger für Empfang und Demodulation von analog modulierten Empfangssignalen sind gegenüber Phasenrauschen weniger empfindlich.

Rundfunkempfangssignale, insbesondere Fernsehempfangssignale, werden zunehmend digital moduliert übertragen. Digitales Fernsehen startete in Deutschland im Sommer 1996 mit dem Pay-TV-Sender DF1. Daneben werden Rundfunksignale, insbesondere Fernsehsignale, weiterhin analog moduliert übertragen. In der US-A-5 408 202 ist ein Phasenregelkreis gezeigt mit einem spannungsgesteuerten Oszillator, einem einstellbaren Frequenzteiler, einem Referenz-Oszillator, einem Phasenvergleicher und einem Schleifenfilter. Über eine Ansteuerschaltung ist die Verstärkung der Phasenvergleichsschaltung einstellbar. In Abhängigkeit von der Einstellung der Schleifenverstärkung wird eine Optimierung des Rauschverhaltens erreicht.

In der US-A-5 631 587 ist ein Frequenzsynthesizer mit einstellbarer Schleifenbandbreite gezeigt. Die Schleifenverstärkung ist durch Steuerung des Ladestroms der Ladungspumpe einstellbar.

In der JP-A-11 122101 ist ein Phasenregelkreis beschrieben, der einen Frequenzteiler im Rückkopplungspfad sowie einen Referenzfrequenzteiler aufweist, wobei zur Verbesserung des Rauschverhaltens ein einstellbarer Verstärker vorgesehen ist.

In der JP-A-09 232950 ist eine PLL-Schaltung gezeigt, deren Schleifenverstärkung durch Steuerung des Ladestroms einer Ladungspumpe einstellbar ist. Es ist daher die Aufgabe der vorliegenden Erfindung, einen Phasenregelkreissystem zu schaffen, bei dem das Phasenrauschverhalten optimiert ist.

Diese Aufgabe wird erfindungsgemäß durch ein Phasenregelkreissystem mit den in Patentanspruch 1 angegebenen Merkmalen gelöst.

Ein Vorteil des erfindungsgemäßen Phasenregelkreissystems besteht darin, daß es sich sowohl für den Empfang von digital modulierten als auch von analog modulierten Rundfunk-Empfangssignalen eignet.

Gemäß der Erfindung wird ein Phasenregelkreissystem zur Abstimmung der Empfangsfrequenz eines Empfängers für digital und analog modulierte Empfangssignale geschaffen mit mindestens einem spannungsgesteuerten Oszillator zur Erzeugung eines Oszillatorsignals für die Empfangsfrequenzabstimmung, einem ersten Frequenzteiler zur Teilung der Frequenz des Oszillatorsignals auf eine Soll-Vergleichsfrequenz in Abhängigkeit von einem Empfangskanal-Auswahlsignal, einem Referenz-Oszillator zur Abgabe eines Referenz-Oszillatorsignals mit einer bestimmten Referenzfrequenz, einem zweiten Frequenzteiler zur Teilung der Referenzfrequenz in Abhängigkeit von einem Empfangsart-Umschaltsignal, einer Phasenvergleichsschaltung zum Vergleich der von den Frequenzteilern abgegebenen Signale zur Erzeugung einer Abstimmspannung für den spannungsgesteuerten Oszillator, wobei die Verstärkung der Phasenvergleichsschaltung zur Optimierung des Phasenrauschens einstellbar ist, wobei das Empfangssignal durch eine Multipliziereinrichtung mit dem Oszillatorsignal zur Erzeugung eines Zwischenfrequenzsignals multiplizierbar ist, der Multipliziereinrichtung eine Phasenrauschen-Erfassungsschaltung zur Erfassung des Phasenrauschens des Zwischenfrequenzsignals nachgeschaltet und die Verstärkung der Phasenvergleichsschaltung in Abhängigkeit von einem Steuersignal einstellbar ist, das von der Phasenrauschen-Erfassungsschaltung erzeugt wird.

Bei einer bevorzugten Ausführungsform des erfindungsgemäßen Phasenregelkreissystems besteht die Phasenvergleichsschaltung aus einem Phasenkomparator und einer Ladungspumpe, wobei die Verstärkung der Phasenvergleichsschaltung durch einen Ladestrom einstellbar ist, der durch die Ladepumpe erzeugt wird.

Vorzugsweise ist der Mischereinrichtung eine automatische Verstärkungsregelschaltung nachgeschaltet, die das Empfangssignal in Abhängigkeit von der Amplitude des Zwischenfrequenzsignals verstärkt.

Bei einer weiteren vorteilhaften Ausgestaltung des erfindungsgemäßen Phasenregelkreissystems wird der Ladestrom, der von der Ladungspumpe abgegeben wird, in Abhängigkeit von einem Steuersignal eingestellt, das von einer mit der Ladungspumpe verbundenen Steuerung erzeugt wird.

Bei einer weiteren vorteilhaften Ausgestaltung des erfindungsgemäßen Phasenregelkreissystems ist der erste Frequenzteiler zwischen einer Vielzahl von Frequenzteilungsverhältnissen in Abhängigkeit von dem Empfangskanalauswahlsignal schaltbar, wobei für jeden auswählbaren Empfangskanal jeweils ein Frequenzteilungsverhältnis für den Empfang eines analog und eines digital modulierten Empfangssignals in einem Speicher abgespeichert ist.

Bei einer weiteren vorteilhaften Ausgestaltung des erfindungsgemäßen Phasenregelkreissystems ist der zweite Frequenzteiler zwischen einem ersten Frequenzteilungsverhältnis für ein analog moduliertes Empfangssignal und einem zweiten Frequenzteilungsverhältnis für ein digital moduliertes Empfangssignal durch eine Schalteinrichtung umschaltbar.

Bei einer weiteren vorteilhaften Ausgestaltung des erfindungsgemäßen Phasenregelkreissystems wird die Abstimmspannung durch ein Schleifenfilter gefiltert.

Vorzugsweise ist der Multipliziereinrichtung mindestens ein Signalverstärker und ein Signaloberflächenwellen-Bandpaßfilter nachgeschaltet.

Bei einer weiteren vorteilhaften Ausgestaltung des erfindungsgemäßen Phasenregelkreissystems ist der Referenz-Oszillator ein Quarzkristall.

Der erste Frequenzteiler des erfindungsgemäßen Phasenregelkreissystems ist vorzugsweise mit einer Empfangskanal-Auswahleinrichtung zur Erzeugung des Empfangskanal-Auswahlsignals verbunden.

Bei einer bevorzugten Ausführungsform des erfindungsgemäßen Phasenregelkreissystems ist der Multipliziereinrichtung eine Phasenrauschen-Erfassungsschaltung zur Erfassung des Phasenrauschens des Zwischenfrequenzsignals nachgeschaltet. Die Verstärkung der Phasenvergleichsschaltung ist bei einer bevorzugten Ausführungsform in Abhängigkeit von einem Steuersignal einstellbar, das von der Phasenrauschen-Erfassungsschaltung erzeugt wird.

Dies bietet den besonderen Vorteil, daß das Phasenrauschen automatisch in Abhängigkeit von dem erfaßten Phasenrauschen des Zwischenfrequenzsignals minimiert wird.

Bei einer weiteren bevorzugten Ausführungsform des erfindungsgemäßen Phasenregelkreissystems beträgt die Soll-Vergleichsfrequenz 62,5 kHz für analog modulierte Empfangssignale und 166,7 kHz für digital modulierte Empfangssignale.

Bei einer alternativen Ausführungsform des erfindungsgemäßen Phasenregelkreissystems beträgt die Soll-Vergleichsfrequenz 62,5 kHz für analog modulierte Empfangssignale und 250 kHz für digital modulierte Empfangssignale.

Der Referenz-Oszillator erzeugt vorzugsweise ein Referenz-Oszillatorsignal mit einer Frequenz von 4 MHz.

Der zweite Frequenzteiler ist vorzugsweise zwischen einem Frequenzteilungsverhältnis von 64 für ein analog moduliertes Empfangssignal und einem Frequenzteilungsverhältnis von 24 für ein digital moduliertes Empfangssignal umschaltbar.

Bei einer alternativen Ausführungsform des erfindungsgemäßen Phasenregelkreissystems ist der zweite Frequenzteiler zwischen einem Frequenzteilungsverhältnis von 64 für ein analog moduliertes Empfangssignal und einem Frequenzteilungsverhältnis von 16 für ein digital moduliertes Empfangssignal umschaltbar. Bei einer bevorzugten Ausführungsform weist das erfindungsgemäße Phasenregelkreissystem eine Modulationsart-Erkennungsschaltung auf, die erkennt, ob das Empfangssignal digital oder analog moduliert ist.

Die Modulationsart-Erkennungsschaltung steuert vorzugsweise die Schalteinrichtung zum Umschalten des zweiten Frequenzteilers zwischen dem ersten Frequenzteilungsverhältnis für ein analog moduliertes Empfangssignal und dem Frequenzteilungsverhältnis für ein digital moduliertes Empfangssignal.

Dies bietet den besonderen Vorteil, daß die Umschaltung des Frequenzteilungsverhältnisses in Abhängigkeit von der erkannten Modulationsart automatisch erfolgt.

Im weiteren wird eine bevorzugte Ausführungsform des erfindungsgemäßen Phasenregelkreissystems zur Erläuterung erfindungswesentlicher Merkmale unter Bezugnahme auf die beigefügten Zeichnungen beschrieben.

Es zeigen:

Fig. 1    eine bevorzugten Ausführungsform des Phasenregelkreissystems gemäß der Erfindung;

Fig. 2    ein schematisches Diagramm des Frequenzverlaufs des Phasenrauschens beim Empfänger nach dem Stand der Technik und bei einem Empfänger, bei dem das erfindungsgemäße Phasenregelkreissystem eingesetzt ist;

Fig. 3    ein Diagramm zur Darstellung des Frequenzverlaufs des Phasenrauschens bei einem Empfänger nach dem Stand der Technik und bei einem Empfänger, bei dem das erfindungsgemäße Phasenregelkreissystem eingesetzt ist;

Fig. 4A bis 4F    Diagramme zur Darstellung des Phasenrauschens in Abhängigkeit von der Frequenz bei unterschiedlichen Empfangsträger-Mittenfrequenzen und verschiedenen Frequenzteilungsverhältnissen bei Empfang eines analog modulierten und eines digital modulierten Empfangssignals;

Fig. 5A bis 5D    Diagramme zur Darstellung des Phasenrauschens in Abhängigkeit von der Frequenz bei unterschiedlichen Empfangsträger-Mittenfrequenzen und unterschiedlichen Frequenzteilungsverhältnissen für den Empfang von analog modulierten oder digital modulierten Empfangssignalen;

Fig. 6A, B    Diagramme zur Darstellung des Phasenrauschens in Abhängigkeit von der Frequenz für unterschiedliche Ladeströme der Phasenvergleichsschaltung gemäß der Erfindung;

Fig. 7    ein Diagramm zur Darstellung der Abstimmsteilheit eines spannungsgesteuerten Oszillators in Abhängigkeit von der Empfangsträger-Mittenfrequenz für unterschiedliche Empfangsfrequenzbereiche.

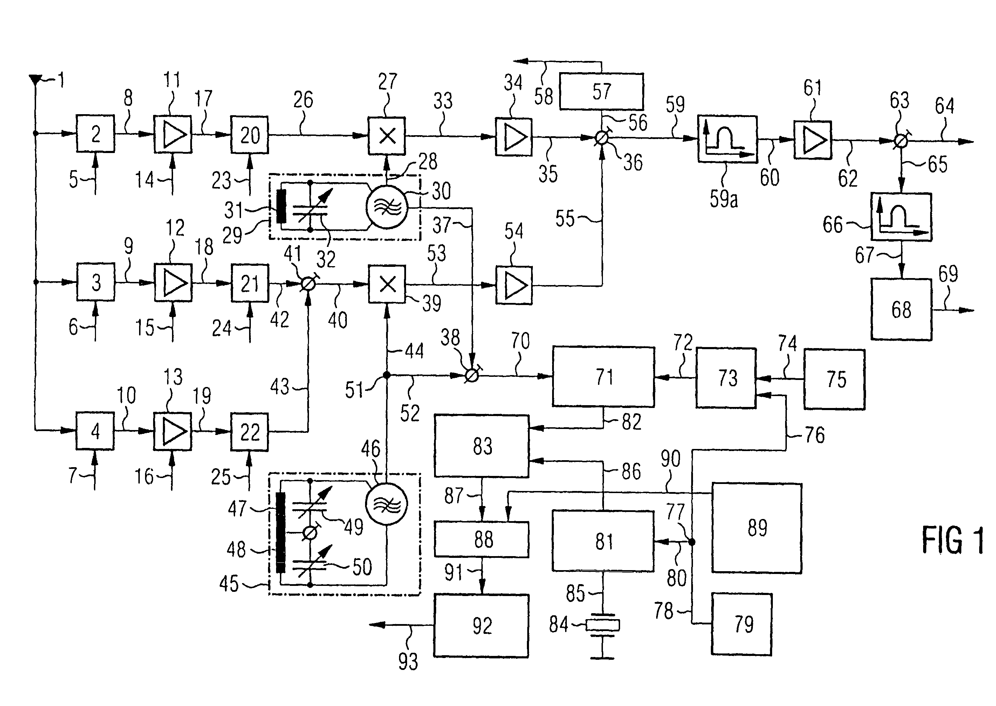

Fig. 1 zeigt einen Ausschnitt eines Empfängers zum Empfang von digital und/oder analog modulierten Rundfunk-Empfangssignalen, insbesondere Fernsehsignalen, bei dem das erfindungsgemäße Phasenregelkreissystem eingesetzt wird.

Der Rundfunkempfänger weist eine Antenne 1 auf, durch die digital oder analog modulierte Empfangs-Rundfunksignale, beispielsweise Fernsehsignale, empfangen werden. Die Rundfunk-Empfangssignale liegen vorzugsweise in einem Bereich von 0 bis 900 MHz. Das empfangene Rundfunksignal wird parallel drei verschiedenen einstellbaren Bandpaßfiltern 2, 3, 4 zugeführt. Die Durchlaßfrequenzbereiche der Bandpaßfilter 2, 3, 4 sind vorzugsweise durch eine Einstellspannung über Steuerleitungen 5, 6, 7 einstellbar. Die Bandpaßfilter 2, 3, 4 filtern selektiv alle Empfangssignale aus, die nicht innerhalb der jeweils eingestellten Empfangsfrequenzbereiche liegen. Die einstellbaren Empfangsfrequenzbereiche sind vorzugsweise die VHF-Empfangsfrequenzbereiche (VHF: Very High Frequency bzw. Ultrakurzwelle) und der UHF-Empfangsfrequenzbereich (UHF: Ultra High Frequency).

Die jeweils gefilterten Empfangssignale gelangen über Signalleitungen 8, 9, 10 zu Signalverstärkern 11, 12, 13. Die Verstärkung durch die Signalverstärker 11, 12, 13 ist vorzugsweise jeweils über Verstärkungs-Einstelleitungen 14, 15, 16 einstellbar. Ausgangsseitig sind die Signalverstärker 11, 12, 13 über Leitungen 17, 18, 19 mit weiteren einstellbaren Bandpaßfiltern 20, 21, 22 verbunden. Die Durchlaß-Frequenzbereiche der Bandpaßfilter 20, 21, 22 sind vorzugsweise jeweils über Einstelleitungen 23, 24, 25 einstellbar. Vorzugsweise entsprechen die Durchlaß-Frequenzbereiche der Bandpaßfilter 20, 21, 22 jeweils den Durchlaß-Frequenzbereichen der Bandpaßfilter 2, 3, 4.

Bei der in Fig. 1 dargestellten bevorzugten Ausführungsform ist der Empfangsfrequenz-Durchlaßbereich der Bandpaßfilter 2, 20 der VHFI-Empfangsfrequenzbereich. Der Empfangsfrequenz-Durchlaßbereich der Bandpaßfilter 3, 21 ist der VHFII-Empfangsfrequenzbereich, und der Durchlaß-Empfangsfrequenzbereich der Bandpaßfilter 4, 22 ist vorzugsweise der UHF-Empfangsfrequenzbereich. Die Ausgangsleitung 26 des Bandpaßfilters 20 leitet das gefilterte Empfangssignal im VHF-Empfangsfrequenzbereich zu einem Mischer bzw. einer Multipliziereinrichtung 27. Die Multipliziereinrichtung 27 multipliziert das gefilterte Empfangssignal mit einem über eine Leitung 28 zugeführten Oszillatorsignal. Das Oszillatorsignal wird durch einen ersten Oszillator 29 erzeugt, der einen Verstärker 30 und ein frequenzabhängiges Rückkopplungsnetzwerk enthält, wobei das frequenzabhängige Rückkopplungsnetzwerk des in Fig. 1 dargestellten Oszillatorschaltkreises 29 aus einer Spule 31 und einer dazu parallel geschalteten Kapazität 32 besteht. Die Kapazität 32 ist vorzugsweise durch eine Abstimmspannung einstellbar und wird durch eine Varaktordiode gebildet. Ausgangsseitig ist die Mischeinrichtung 27 über eine Leitung 33 mit einem Signal verstärker 34 verbunden. Durch die Multiplikation des auf der Leitung 26 anliegenden gefilterten Empfangssignals mit dem auf der Leitung 28 anliegenden Oszillatorsignal wird ein Zwischenfrequenzsignal erzeugt, das eine Zwischenfrequenz aufweist. Die Zwischenfrequenz wird gebildet durch die Differenz der Oszillatorsignalfrequenz und der Empfangsfrequenz. Das über die Leitung 33 abgegebene Zwischenfrequenzsignal wird durch die Signalverstärkungseinrichtung 34 verstärkt und über eine Leitung 35 an einen Knoten 36 abgegeben. Der spannungsgesteuerte Oszillator 29 zur Erzeugung des Oszillatorsignals gibt das Oszillatorsignal ferner über eine Leitung 37 an einen Knoten 38 ab.

Der in Fig. 1 dargestellte Empfänger enthält einen zweiten Mischer bzw. eine zweite Multipliziereinrichtung 39. Die Multipliziereinrichtung 39 ist über eine Eingangsleitung 40 mit einem Summenknoten 41 verbunden. Der Summenknoten 41 liegt über eine Leitung 42 am Ausgang des Bandpaßfilters 21 und über eine Leitung 43 am Ausgang des Bandpaßfilters 22 an. Die Multipliziereinrichtung 39 multipliziert das an der Eingangsleitung anliegende gefilterte hochfrequente Empfangssignal mit einem an einer Leitung 44 anliegenden Oszillatorsignal, das durch einen spannungsgesteuerten Oszillator 45 erzeugt wird. Der Oszillator 45 enthält bei dem in Fig. 1 gezeigten Ausführungsbeispiel eine Verstärkereinrichtung 46, die an einem frequenzabhängigen Rückkopplungsnetzwerk angeschlossen ist. Das Rückkopplungsnetzwerk besteht bei dem gezeigten Beispiel aus zwei Schwingkreisen. Die beiden Schwingkreise bestehen jeweils aus einer Spule 47, 48 und einer dazu parallel geschalteten Kapazität 49, 50. Die Kapazitäten sind dabei einstellbar. Vorzugsweise werden die einstellbaren Kapazitäten der Schwingkreise durch spannungsgesteuerte Varakterdioden gebildet. Durch den spannungsgesteuerten Oszillator 45 sind zwei Oszillatorsignale mit unterschiedlichen Oszillatorfrequenzen erzeugbar. Dabei dient die erste Oszillatorfre-quenz zur Multiplikation mit Empfangssignalen, die im Durchlaß-Frequenzbereich der Bandpaßfilter 3, 21 liegen, wohingegen das zweite durch den Oszillator 45 erzeugte Oszillatormischsignal zur Multiplikation mit denjenigen Empfangssignalen verwendet wird, die in dem Durchlaß-Frequenzbereich der Bandpaßfilter 4, 22 liegen. Am Knoten 51 wird das durch den Oszillator 45 gebildete Oszillatorsignal abgegriffen und über eine Leitung 52 dem Knoten 38 zugeführt. Die Mischeinrichtung 39 multipliziert das an der Eingangsleitung 40 anliegende hochfrequente gefilterte Empfangssignal mit dem an der Leitung 44 anliegenden Oszillatorsignal zur Erzeugung eines Zwischenfrequenzsignals, das über eine Ausgangsleitung 53 der Multipliziereinrichtung 39 zu einem Signaleingang eines Signalverstärkers 54 geleitet wird. Der Signalverstärker 54 verstärkt das empfangene Zwischenfrequenzsignal und gibt es über eine Ausgangsleitung 55 an den Knoten 36 ab.

An dem Knoten 36 ist über eine Leitung 56 eine Verstärkungsregelschaltung 57 angeschlossen, die in Abhängigkeit von der Amplitude der an dem Knoten 36 anliegenden Zwischenfrequenzsignale über eine Steuerleitung 58 die Signalverstärkung der Verstärker 11, 12, 13 einstellt. Die Steuerleitung 58 ist vorzugsweise mit den Steuerleitungen 14, 15, 16 verbunden. Die Verstärkungsregelschaltung 57 regelt die Verstärkung der Verstärker 11, 12, 13 derart, daß die Amplitude des Zwischenfrequenzsignals am Knoten 36 möglichst konstant bei einem gewünschten Signalpegel liegt.

Das an dem Knoten 36 anliegende Zwischenfrequenzsignal wird über eine Leitung 59 einem SAW-Bandpaßfilter 59a zugeführt, dessen über eine Ausgangsleitung 60 abgegebenes gefiltertes Ausgangssignal durch einen nachgeschalteten Signalverstärker 61 verstärkt über eine Leitung 62 an einen Ausgangsknoten 63 angelegt wird. Handelt es sich bei dem Empfangssignal um ein analog moduliertes Rundfunksignal, wird dies über eine Leitung 64 zur weiteren Signalverarbeitung weitergeleitet.

Bei einer bevorzugten Ausführungsform beträgt die Zwischenfrequenz des an dem Knoten 63 anliegenden Zwischenfrequenzsignals 36 MHz. Das an dem Knoten anliegende Zwischenfrequenzsignal wird über eine Leitung 65 einem weiteren SAW-Bandpaßfilter 66 zugeführt, der ausgangsseitig über eine Leitung 67 an einer Mischverstärkungseinrichtung 68 angeschlossen ist. Die Mischverstärkungseinrichtung 68 mischt das empfangene gefilterte Signal derart, daß sich die Frequenz von 36 MHz auf 7 MHz vermindert, und verstärkt gleichzeitig die Signalamplitude. Das von der Mischverstärkungseinrichtung 68 abgegebene Signal wird als digital moduliertes Zwischenfrequenzsignal über eine Leitung 69 zur weiteren Signalverarbeitung abgegeben.

Die an dem Knoten 38 anliegenden Ausgangs-Oszillatorsignale der spannungsgesteuerten Oszillatoren 29, 45 werden über eine Leitung 70 einem Frequenzteiler 71 zugeleitet, der die Frequenz der anliegenden Oszillatorsignale auf eine Soll-Vergleichsfrequenz in Abhängigkeit von einem Steuersignal teilt, das über eine Leitung 72 aus einer Speichereinrichtung 73 ausgelesen wird. In der Speichereinrichtung 73 ist eine Vielzahl von Frequenzteilungsverhältnissen abgespeichert. Die Speichereinrichtung 73 erhält über eine Auswahlleitung 74 ein Empfangskanal-Auswahlsignal von einer Empfangskanal-Auswahleinrichtung 75. Über die Empfangskanal-Auswahleinrichtung 75 kann durch eine Bedienperson oder durch ein Programm ein gewünschter Empfangskanal ausgewählt werden. Die Speichereinrichtung 73 ist ferner über eine Leitung 76 mit einem Knoten 77 verbunden, an dem über eine Leitung 78 eine Schalteinrichtung 79 angeschlossen ist. Der Frequenzteiler 71 ist programmierbar und ist zwischen einer Vielzahl von Frequenzteilungsverhältnissen schaltbar, die in der Speichereinrichtung 73 tabellenförmig abgespeichert sind. Für jeden über die Empfangskanal-Auswahleinrichtung 75 ausgewählten Empfangskanal ist jeweils ein Frequenzteilungsverhältnis für ein analog moduliertes und ein digital moduliertes Empfangssignal abgespeichert.

Die Schalteinrichtung 79 schaltet über eine Leitung 80 einen weiteren programmierbaren Frequenzteiler 81 zwischen einem ersten Frequenzteilungsverhältnis für ein analog moduliertes Empfangssignal und einem zweiten Frequenzteilungsverhältnis für ein digital moduliertes Empfangssignal.

Der Frequenzteiler 71 teilt das über die Leitung 70 empfangene Oszillatorsignal, welches durch die Oszillatoren 29, 45 erzeugt wird, durch das aus der Speichereinrichtung 73 über die Leitung 72 ausgelesene erste Frequenzteilungsverhältnis und gibt das bezüglich der Frequenz geteilte Signal über eine Leitung 82 an einen Phasen- bzw. Frequenzkomparator 83 ab.

Ein Referenz-Oszillator 84 erzeugt ein.Referenz-Oszillatorsignal, das über eine Leitung 85 an dem Frequenzteiler 81 anliegt. Der Frequenzteiler 81 teilt die Frequenz des anliegenden Referenz-Oszillatorsignals entsprechend einem Frequenzverhältnis, das durch die Schalteinrichtung 79 umschaltbar ist. Die Schalteinrichtung 79 schaltet das Frequenzteilungsverhältnis des Frequenzteilers 81 zwischen einem ersten Frequenzteilungsverhältnis für ein analog moduliertes Empfangssignal und einem zweiten Frequenzteilungsverhältnis für ein digital moduliertes Empfangssignal. Das entsprechend dem eingestellten Frequenzteilungsverhältnis geteilte Referenz-Oszillatorsignal wird von dem Frequenzteiler 81 über eine Ausgangsleitung 86 ebenfalls dem Phasenkomparator 83 zugeführt.

Der Phasenkomparator 83 ist über eine Ladestromleitung 87 mit einer Ladungspumpe 88 verbunden. Der Phasenkomparator 83 bildet zusammen mit der Ladungspumpe 88 eine Phasenvergleichsschaltung, deren Verstärkung in Abhängigkeit von dem durch die Ladepumpe 88 erzeugten Ladestrom einstellbar ist. Die Stärke des durch die Ladungspumpe 88 erzeugten Ladestroms wird durch eine Ladungspumpensteuerung 89 über eine Steuerleitung 90 eingestellt. Die Ladungspumpe 88 ist weiterhin über eine Leitung 91 mit einem PLL- bzw. Schleifenfilter 92 verbunden. Das Schleifenfilter 92 gibt über eine Leitung 93 eine Abstimmspannung zum Abgleich bzw. Abstimmen der in den Schwingkreisen der Oszillatoren 29, 45 enthaltenen einstellbaren Kapazitäten 32, 49, 50 ab. Durch die an der Leitung 93 anliegende Abstimmspannung werden vorzugsweise die in den Schwingkreisen vorgesehenen Varaktordioden 32, 49, 50 derart abgestimmt und somit die Oszillatorfrequenz der Oszillatoren 29, 45 derart eingestellt, daß die Phasen- bzw. Frequenzdifferenz an den Eingangsleitungen 82, 86 des Phasenkomparators 83 minimal wird.

Bei analog modulierten Rundfunk-Fernsehempfangssignalen nach dem PAL- bzw. SECAM-Standard beträgt die Soll-Vergleichsfrequenz, die an der ersten Eingangsleitung 82 des Phasenkomparators 83 anzuliegen hat, 62,5 kHz. Bei digital modulierten Rundfunk-Empfangssignalen, die ein OFDM-Zeitmultiplexverfahren verwenden, beträgt die Soll-Vergleichsfrequenz 166,67 kHz. In Abhängigkeit davon, ob ein analog moduliertes Rundfunk-Empfangssignal oder ein digital moduliertes Rundfunk-Empfangssignal durch den in Fig. 1 dargestellten Empfänger empfangen wird, wird aus der Speichereinrichtung 73 in Abhängigkeit von dem Empfangskanal-Auswahlsignal, das durch die Empfangskanal-Auswahleinrichtung 75 eingestellt wird, ein bestimmtes Frequenzteilungsverhältnis in dem Frequenzteiler 71 eingestellt. Die Einstellung erfolgt derart, daß die Frequenz des an der Leitung 70 anliegenden Oszillatorsignals so geteilt wird, daß an der Leitung 82 die Soll-Vergleichsfrequenz von 62,5 kHz beim Empfang eines analog modulierten Empfangssignals anliegt und eine Soll-Vergleichsfrequenz von 166,7 kHz für den Fall anliegt, daß ein digital moduliertes Empfangssignal empfangen wird.

Der Referenz-Oszillator 84 ist vorzugsweise ein Quarzkristall. Dieses Quarzkristall gibt bei einer bevorzugten Ausführungsform ein Referenz-Oszillatorsignal mit einer Referenzfrequenz von 4 MHz ab. Der Frequenzteiler 81 ist zwischen einem ersten Frequenzteilungsverhältnis von 64 für ein analog moduliertes Empfangssignal und einem zweiten Frequenzteilungsverhältnis von 24 für ein digital moduliertes Empfangssignal durch die Schalteinrichtung 79 umschaltbar. Bei einer alternativen Ausführungsform beträgt das Frequenzteilungsverhältnis für ein digital moduliertes Empfangssignal 16. Gibt das Quarzkristall 84 ein Referenz-Oszillatorsignal mit einer Referenzfrequenz von 4 MHz ab, wird durch den Frequenzteiler 81 dieses sinusförmige Referenzsignal auf eine Frequenz von 62,5 kHz beim Empfang eines analog modulierten Empfangssignals heruntergeteilt. Bei Empfang eines digital modulierten Empfangssignals wird das Frequenzteilungsverhältnis des Frequenzteilers 81 bei einer ersten Ausführungsform auf 24 eingestellt, so daß die Referenz-Oszillatorfrequenz von 4 MHz auf die Soll-Vergleichsfrequenz von 166,7 kHz geteilt wird. Bei einer bevorzugten Ausführungsform beträgt das Frequenzteilungsverhältnis des Frequenzteilers 81 bei Empfang eines digital modulierten Empfangssignals 16, so daß die Soll-Vergleichsfrequenz 250 kHz beträgt.

Wie aus Fig. 1 hervorgeht, wird das Frequenzteilungsverhältnis des Frequenzteilers 81 durch die Schalteinrichtung 79 eingestellt. Wird der Empfang eines digital modulierten Empfangssignals erwartet, schaltet die Schalteinrichtung 79 den Frequenzteiler auf das Frequenzteilungsverhältnis für digital modulierte Empfangssignale, beispielsweise auf 16 oder 24. Wird der Empfang eines analog modulierten Empfangssignals erwartet, schaltet man mit der Schalteinrichtung 79 das Frequenzteilungsverhältnis des Frequenzteilers 81 auf 64, so daß die durch den Standard vorgegebene Soll-Vergleichsfrequenz von 62,5 kHz an der Leitung 86 erreicht wird.

Bei einer weiteren, nicht gezeigten Ausführungsform enthält der Demodulator eine Modulationsart-Erkennungsschaltung, die automatisch erkennt, ob das empfangene Rundfunksignal, insbesondere das empfangene Fernsehempfangssignal, analog oder digital moduliert ist. Diese Modulationsart-Erkennungsschaltung steuert vorzugsweise die in Fig. 1 dargestellte Schalteinrichtung 79 derart, daß die entsprechenden Frequenzteilungsverhältnisse innerhalb des Frequenzteilers 81 automatisch entsprechend der Modulationsart des empfangenen Rundfunksignals angepaßt werden. Erkennt die Modulationsart-Erkennungsschaltung, daß das empfangene Rundfunksignal digital moduliert ist, wird das Frequenzteilungsverhältnis vorzugsweise auf 24 bzw. 16 eingestellt. Erkennt umgekehrt die Modulationsart-Erkennungsschaltung, daß das empfangene Rundfunksignal analog moduliert ist, wird die Schalteinrichtung 79 derart angesteuert, daß diese das Frequenzteilungsverhälnis des Frequenzteilers 81 auf 64 schaltet. Der Phasenkomparator 83 vergleicht die Phase bzw. die Frequenz der beiden an den Leitungen 82, 86 anliegenden Signale und stimmt die Schwingkreise der Oszillatoren 29, 45 derart ab, daß die Frequenz des an der Leitung 82 anliegenden Signals möglichst genau mit der an der Leitung 86 anliegenden Soll-Vergleichsfrequenz übereinstimmt. Die Phasen- bzw. Frequenzdifferenz zwischen den beiden an den Leitungen 82, 86 anliegenden Signalen ist vorzugsweise null. Hierdurch wird gewährleistet, daß die Phasenschwankung minimal wird. Entsteht an den Eingängen 82, 86 des Phasenkomparators 83 eine Phasen- bzw. Frequenzabweichung von der Soll-Vergleichsfrequenz, werden über die Abstimmleitung 93 die Varaktordioden 32, 49, 50 solange abgeglichen, bis die Phasendifferenz zwischen den beiden an den Leitungen 82, 86 anliegenden Signalen null beträgt.

Die Soll-Vergleichsfrequenz an der Leitung 86 wird durch den jeweiligen Signalübertragungsstandard festgelegt. Sie beträgt bei DVB-T, bei dem eine digitale Modulation erfolgt, 166,7 kHz und bei dem PAL- bzw. SECAM-Übertragungsstandard, der eine analoge Modulation verwendet, 62,5 kHz.

Durch die Oszillatoren 29, 45 entsteht ein Phasenrauschen, das durch das Phasenregelkreissystem gemäß der Erfindung minimiert wird.

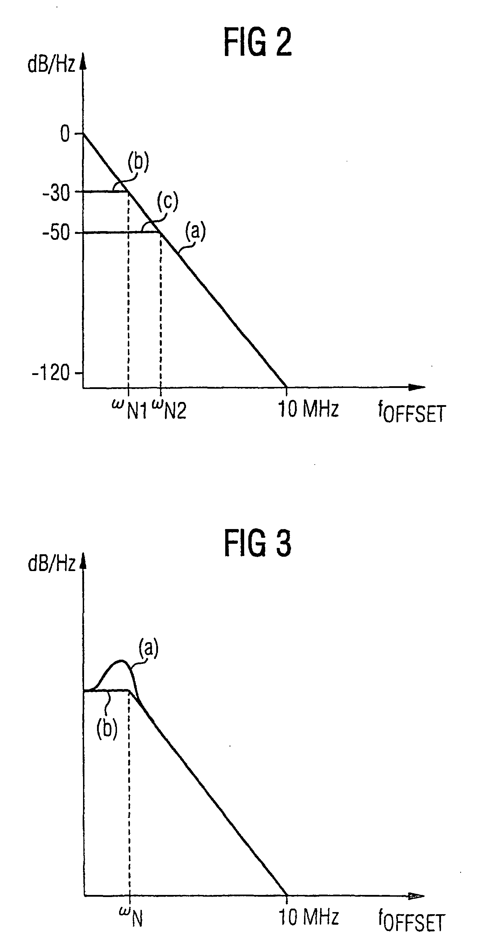

Fig. 2 zeigt ein Diagramm einer typischen Frequenzabhängigkeit des Phasenrauschens. Dabei ist die Amplitude des Phasenrauschens bezogen auf die Signalspitze in Abhängigkeit von einer Offset-Frequenz gezeigt. Die Offset-Frequenz ist die Frequenzabweichung von der Resonanz- bzw. Oszillatorfrequenz des Oszillators bzw. der Trägermittenfrequenz. Die Kurve a zeigt die Abhängigkeit des Phasenrauschens eines Empfängers, wenn kein Phäsenregelkreis verwendet wird. In diesem Fall fällt bei logarithmischer Darstellung der Offset-Frequenz die Amplitude des Phasenrauschens linear mit zunehmender Frequenzabweichung von der Trägermittenfrequenz ab. Die Kurve b stellt die Frequenzabhängigkeit des Phasenrauschens bei Verwendung eines herkömmlichen PLL-Phasenregelkreissystems dar. Wie man aus Fig. 2 erkennen kann, wird bei Verwendung eines herkömmlichen PLL-Phasenregelkreises das Phasenrauschen bis zu einer Phasenregelkreis-Bandbreite bzw. Loop-Bandbreite $\omega_n$ auf -30 dB bezogen auf die Maximalamplitude des Oszillators gedämpft. Durch das erfindungsgemäße Phasenregelsystem wird, wie durch die Kurve c angedeutet, das Phasenrauschen bis zu einer Loop-Bandbreite $\omega_{n2}$ auf -50 dB gedämpft. Das erfindungsgemäße Phasenregelsystem, wie es in Fig. 1 dargestellt ist, wird somit zu einer erheblichen Verminderung des unerwünschten Phasenrauschens.

Die Loop-Bandbreite $\omega_n$ und der Dämpfungsfaktor $\zeta$ steigt proportional mit der Wurzel der Steilheit des Oszillators $K_0$, der Verstärkung der Phasenvergleichsschaltung $K_D$, dem inversen Frequenzteilungsverhältnis $1/N_r$ des zweiten Frequenzteilers 81 sowie dem inversen Frequenzteilungsverhältnis $1/N_{RF}$ des ersten Frequenzteilers 71 gemäß folgender Formel:

$$\omega_n, \zeta \sim \frac{K_0 \cdot K_D}{N_r \cdot N_{RF}}$$

Die Abstimmsteilheit $K_0$ der Oszillatoren 29, 45 hängt von der Resonanzfrequenz bzw. der Oszillatorfrequenz ab. Die Oszillatorfrequenz wird ihrerseits durch die Abstimmspannung an der Abstimmleitung 93 des Schleifenfilters 92 bestimmt. Das Frequenzteilungsverhältnis $N_r$ des zweiten Frequenzteilers 81 beträgt 64 für analog modulierte Empfangssignale und vorzugsweise 24 für digital modulierte Empfangssignale. Diese Frequenzteilungsverhältnisse ergeben sich bei einer Referenzfrequenz des Quarzkristalls 84 und erhöhen sich direkt propotional, wenn den Referenz-Oszillatoren mit höheren Referenzfrequenzen verwendet werden. So beträgt das Frequenzteilungsverhältnis bei einem Quarz, der eine Referenzfrequenz von 8 MHz abgibt, 128 für analog modulierte Empfangssignale und vorzugsweise 48 für digital modulierte Empfangssignale.

Das Frequenzteilungsverhältnis des Frequenzteilers 71 zur Teilung der Frequenz des Oszillatorsignals auf eine Soll-Vergleichsfrequenz ist in der Speichereinrichtung 73 abgespeichert. Wird beispielsweise durch die Kanalauswahleinrichtung 75 ein Empfangskanal mit einer Empfangsfrequenz von 800 MHz ausgewählt, wird das an der Leitung 70 anliegende Oszillatorsignal durch den Frequenzteiler 71 bei analog modulierten Empfangssignalen auf die Soll-Vergleichsfrequenz von 62,5 kHz geteilt und bei digital modulierten Empfangssignalen auf die Soll-Vergleichsfrequenz von 166,7 kHz geteilt. Dementsprechend ist in der Speichereinrichtung 73 für den Empfangskanal mit der Empfangsfrequenz von 800 MHz, beispielsweise einem Fernsehsender, ein Frequenzteilungsverhältnis von 12.800 für ein analog moduliertes Empfangssignal und ein Teilungsverhältnis von 4800 für ein digital moduliertes Empfangssignal abgespeichert. Wird durch eine Bedienperson die diesem Empfangskanal zugeordnete Taste in der Empfangskanal-Auswahleinrichtung 75 gedrückt und ist die Schalteinrichtung 79 auf Empfang digital modulierter Signale geschaltet, wird aus der Speichereinrichtung 73 ein Frequenzteilungsverhältnis von 4800 über die Leitung 72 in dem Frequenzteiler 71 eingestellt, so daß ein Oszillatorsignal mit einer Frequenz von 800 MHz auf die Soll-Vergleichsfrequenz von 166,7 kHz entsprechend dem Standard heruntergeteilt wird.

Die Größe der Verstärkung $K_D$ der Phasenvergleichsschaltung ist abhängig von dem durch die Ladepumpe 88 erzeugten Ladestrom. Die Höhe des Ladestroms wird über die Steuerleitung 90 durch eine Ladestromsteuereinrichtung 89 eingestellt. Dabei wird die Verstärkung $K_D$ der Phasenvergleichsschaltung, die aus dem Phasenkomparator 83 und der Ladepumpe 88 besteht, derart eingestellt, daß das Phasenrauschen des Empfängers minimal wird. Wie man aus Fig. 2 erkennen kann,.wird durch das erfindungsgemäße Phasenregelkreissystem das Phasenrauschen bis zu einer Loop-Bandbreite $\omega_{n2}$ auf -50 dB herabgesenkt.

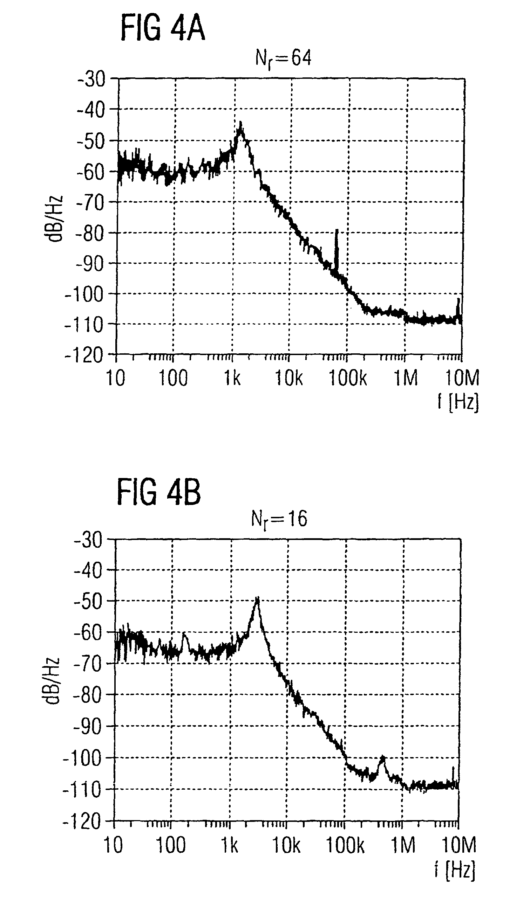

Neben der Amplitude des Phasenrauschens wird durch das erfindungsgemäße Phasenregelkreissystem auch der Dämpfungsfaktor $\zeta$ und somit das Einschwingverhalten optimiert. Fig. 3 zeigt die Frequenzabhängigkeit des Phasenrauschens bei Verwendung eines herkömmlichen Phasenregelkreises als Kurve a und bei Verwendung des erfindungsgemäßen Phasenregelkreissystems als Kurve b. Wie aus Fig. 3 hervorgeht, wird durch das erfindungsgemäße Phasenregelkreissystem der Dämpfungsverlauf optimiert, da die Amplitudenspitze im Bereich der Loop-Bandbreitenfrequenz $\omega_n$ nivelliert verläuft. Der Dämpfungsfaktor wird bei vorgegebenen Frequenzteilungsverhältnissen $N_r$ des zweiten Frequenzteilers 81 sowie des Frequenzteilungsverhältnisses $N_{RF}$ des ersten Frequenzteilers 71 durch geeignete Einstellung der Verstärkung der Phasenvergleichsschaltung $K_D$ derart eingestellt, daß das Phasenrauschen die als Kurve b dargestellte Frequenzabhängigkeit in Fig. 3 aufweist.

Die Figuren 4A bis 4F zeigen verschiedene Frequenzabhängigkeiten des Phasenrauschens bei dem erfindungsgemäßen Phasenregelkreissystems für unterschiedliche Empfangsträger-Mittenfrequenzen bei unterschiedlichen eingestellten Frequenzteilungsverhältnissen $N_r$ des zweiten Frequenzteilers 81.

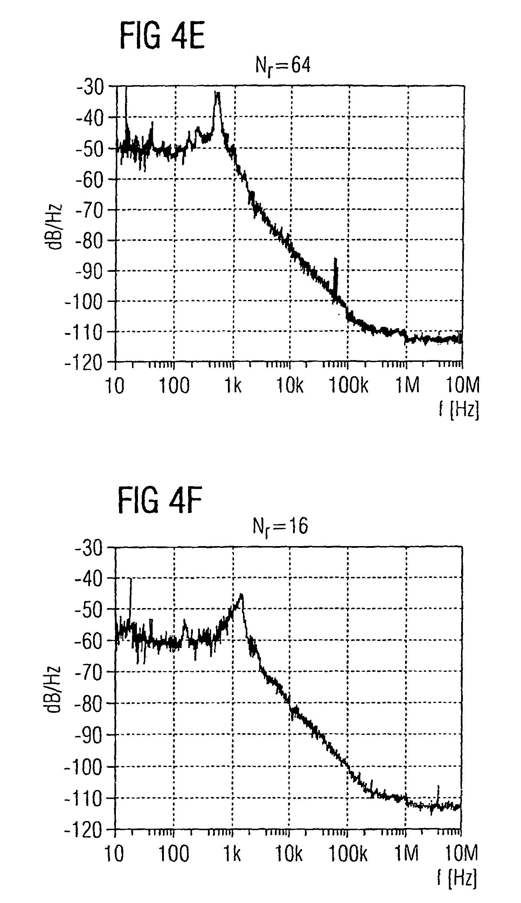

Die Fig. 4A, 4B stellen den Verlauf des Phasenrauschens in Abhängigkeit von der Offset-Frequenz für unterschiedliche Frequenzteilungsverhältnisse $N_r$ für eine Empfangsträger-Mittenfrequenz von 414 MHz dar. Wird ein analog moduliertes Rundfunksignal empfangen, wird das Frequenzteilungsverhältnis $N_r$ zur Teilung der Referenzfrequenz von 4 MHz auf 64 eingestellt, damit die Soll-Vergleichsfrequenz von 166,7 kHz erreicht wird. Bei den Fig. 4A, 4C, 4E ist das Frequenzteilungsverhältnis des zweiten Frequenzteilers 81 auf 64 für den Empfang analog modulierter Rundfunksignale eingestellt.

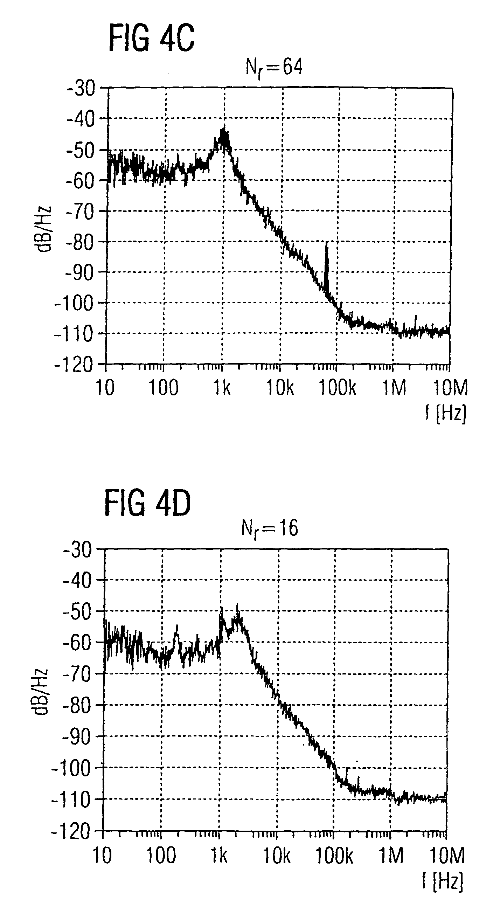

Bei Empfang eines digital modulierten Rundfunksignals wird die Referenzfrequenz von 4 MHz durch ein Frequenzteilungsverhältnis von 16 geteilt, damit eine Soll-Vergleichsfrequenz von 250 kHz erreicht wird. Die Fig. 4B, 4D, 4F zeigen den Verlauf des Phasenrauschens, wenn der zweite Frequenzteiler 81 auf ein Frequenzteilungsverhältnis von 16 zum Empfang eines digital modulierten Empfangssignals eingestellt ist.

Die Fig. 4A, 4B zeigen den Verlauf des Phasenrauschens bei einer Trägermittenfrequenz von 414 MHz im Vergleich. Die Fig. 4A zeigt den Verlauf des Phasenrauschens bei einem Frequenzteilungsverhältnis von 64 für den Empfang analog modulierter Rundfunksignale und die Fig. 4B den Verlauf des Phasenrauschens bei einem eingestellten Frequenzteilungsverhältnis von 16 für den Empfang digital modulierter Rundfunksignale. Wie man aus den Fig. 4A, 4B erkennen kann, ist der Verlauf des Phasenrauschens bei dem erfindungsgemäßen Phasenregelkreissystem optimal. Wie aus Fig. 4A hervorgeht, wird bis zu der Loop-Bandbreite von 1 kHz eine Dämpfung von etwa 60 dB bei der Amplitude des Phasenrauschens erreicht. Die Amplitudenspitze im Bereich der PLL-Loop-Bandbreite $\omega_n$ von 1 kHz ist relativ abgeflacht, und das Phasenrauschen fällt dann mit zunehmender Frequenz in dem linearen Maßstab nahezu linear bis auf ein Niveau von -110 dB ab.

Für die Trägermittenfrequenz von 414 MHz stellt Fig. 4B den Fall dar, daß ein digital moduliertes Empfangssignal empfangen wird. Das Phasenrauschen wird bis zu einer PLL-Loop-Bandbreite von ca. 2,5 kHz bis auf ca. 65 dB gedämpft. Im Bereich der Loop-Bandbreitenfrequenz von 2,5 kHz besteht eine relativ flache Spitze, die mit zunehmender Frequenz im logarithmischen Maßstab linear auf ein Niveau von -110 dB abfällt.

Die Fig. 4C, 4D zeigen den Verlauf des Phasenrauschens bei einer Trägermittenfrequenz von 623 MHz für unterschiedliche Frequenzteilungsverhältnisse. Die Fig. 4C zeigt den Fall, daß ein Frequenzteilungsverhältnis von 64 zum Empfang eines analog modulierten Empfangssignals an dem zweiten Frequenzteiler 81 eingestellt ist. Die Fig. 4D zeigt den Verlauf des Phasenrauschens bei einem eingestellten Frequenzteilungsverhältnis von 16 zum Empfang digital modulierter Empfangssignale. In Fig. 4C beträgt die Loop-Bandbreite etwa 800 Hz, wohingegen die Loop-Bandbreite bei der Fig. 4D in etwa 1,2 kHz beträgt.

Die Fig. 4E, 4F zeigen die Frequenzabhängigkeit des Phasenrauschens bei dem erfindungsgemäßen Phasenregelkreissystem für eine Empfangsträgermittenfrequenz von 847 MHz, wobei in Fig. 4E das Frequenzteilungsverhältnis 64 zum Empfang analog modulierter Rundfunksignale und bei Fig. 4F 16 zum Empfang digital modulierter Rundfunksignale beträgt. Die Loop-Bandbreite ist bei der Fig. 4E etwa 400 Hz und bei der Fig. 4F 1,1 kHz.

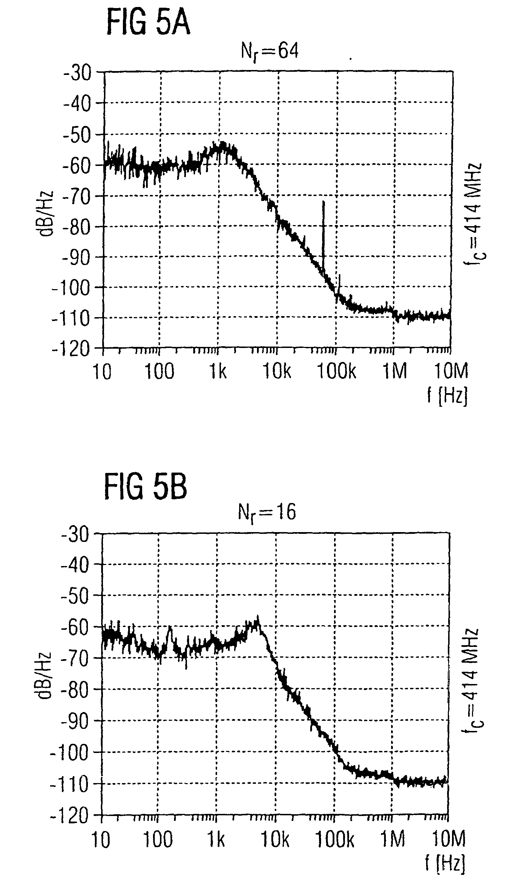

In den Fig. 5A bis 5D wurde das erfindungsgemäße Phasenregelkreissystem derart eingestellt, daß die Spitzen im Bereich der PLL-Loop-Bandbreiten zur Optimierung der Dämpfung abgeflacht verlaufen.

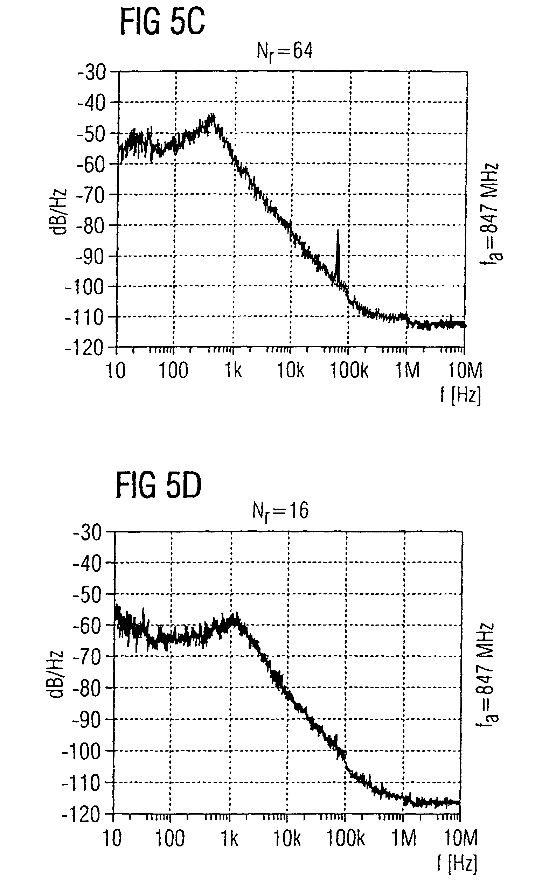

Die Fig. 5A, 5C zeigen den Fall, daß das Frequenzteilungsverhältnis des Frequenzteilers 81 auf 64 zum Empfang analog modulierter Rundfunksignale eingestellt ist. Die Fig. 5B, 5D zeigen den Fall, daß das Frequenzteilungsverhältnis des Frequenzteilers 81 zum Empfang digital modulierter Empfangssignale auf 16 eingestellt ist.

In den Fig. 5A, 5B beträgt die Trägermittenfrequenz 414 MHz, und in den Fig. 5C, 5D beträgt die Trägermittenfrequenz 847 MHz.

Vergleicht man beispielsweise die Fig. 4A und die Fig. 5A, erkennt man, daß die Spitze im Bereich der Loop-Bandbreite von 1 kHz abgeflacht verläuft. Die gleiche Verbesserung erkennt man beim Vergleich der Fig. 5B mit der Fig. 4B. Durch das erfindungsgemäße Phasenregelkreissystem kann daher neben einer absoluten Erhöhung der Dämpfung auch das Einschwingverhalten bzw. der Dämpfungsfaktor optimiert werden. Die Optimierung bezüglich des Einschwingverhaltens ist dabei auch bei höheren Träger-Mittenfrequenzen, wie beispielsweise 847 MHz, möglich, wie durch Vergleich der Fig. 5C, 5D mit den Fig. 4E, 4F ersichtlich.

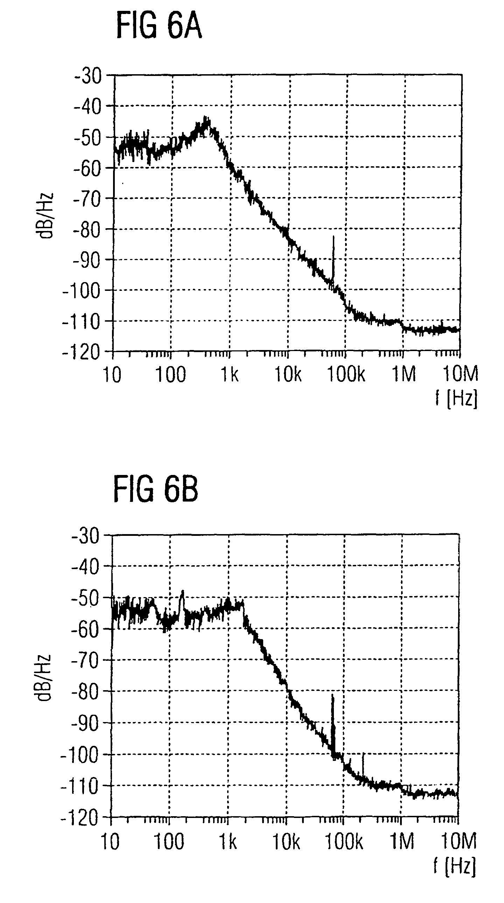

Die Fig. 6 stellt den Verlauf des durch das erfindungsgemäße Phasenregelkreissystem erzielten Phasenrauschens in Abhängigkeit von der Offset-Frequenz dar. Das Frequenzteilungsverhältnis $N_r$ des zweiten Frequenzteilers 81 ist dabei auf 64 für den Empfang analog modulierter Rundfunksignale eingestellt. Die Fig. 6A zeigt den Fall, daß der Ladestrom, der durch die Ladepumpe 88 der Phasenvergleichsschaltung gegeben 5 wird, 50 mA beträgt. Fig. 6B zeigt den Verlauf des Phasenrauschens in Abhängigkeit der Frequenz für den Fall, daß der Ladestrom der Ladepumpe 250 mA beträgt. Wie man durch Vergleich der Fig. 6A, 6B erkennen kann, wird durch die Erhöhung des Ladestroms einerseits eine Absenkung des Phasenrauschens bis zur Loop-Bandbreite erreicht, und andererseits eine Erhöhung der Loop-Bandbreite. Die Loop-Bandbreite beträgt bei dem in Fig. 6B dargestellten Verlauf etwa 1,2 kHz, während die Loop-Bandbreite bei dem in Fig. 6A dargestellten Verlauf bei ca. 400 Hz liegt. Darüber hinaus ist die Spitze im Dämpfungsverlauf im Bereich der Loop-Bandbreitenfrequenz bei Fig. 6B deutlich nivelliert im Vergleich zu dem Verlauf in Fig. 6A. Der Dämpfungsfaktor ist somit in Fig. 6B optimal eingestellt.

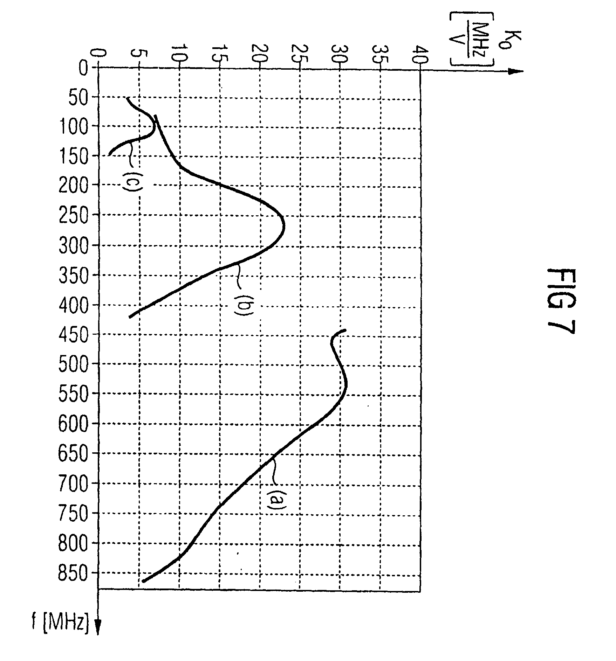

Fig. 7 zeigt die Abstimmsteilheit $K_0$ eines Oszillators in Abhängigkeit von der Empfangsfrequenz für verschiedene Empfangsfrequenzbereiche.

Die Kurve a in Fig. 7 zeigt beispielsweise den Verlauf der Abstimmsteilheit eines typischen Oszillators in Abhängigkeit von der Empfangsfrequenz für den UHF-Empfangsbereich.

Die Kurve b in Fig. 7 stellt die Abstimmsteilheit des gleichen Oszillators für den VHFII-Empfangsbereich dar.

Die Kurve c in Fig. 7 stellt die Abstimmsteilheit des Oszillators für den VHFI-Empfangsbereich dar.

Wie aus Fig. 7 hervorgeht, ist der Verlauf der Abstimmsteilheit für die unterschiedlichen Empfangs-Frequenzbereiche unterschiedlich, wobei der Verlauf in weiten Bereichen nicht linear ist. Der Verlauf der Abstimmsteilheit $K_0$ des Oszillatoren wird bei dem erfindungsgemäßen Phasenregelkreissystem bei der Einstellung der Verstärkung $K_D$ der Phasenvergleichsschaltung zur Optimierung des Phasenrauschens berücksichtigt.

Wie aus dem Kurvenverlauf a in Fig. 7 hervorgeht, ist die Abstimmsteilheit der Oszillatoren in dem UHF-Empfangsbereich weitestgehend indirekt proportional zu der Empfangsfrequenz. Eine Möglichkeit, diese inverse Proportionalität auszugleichen, besteht darin, die Verstärkung $K_D$ der Phasenvergleichsschaltung in Abhängigkeit von dem Teilungsverhältnis $N_{RF}$ des Frequenzteilers 71 und der Abstimmsteilheit $K_0$ zu erhöhen. Dies kann durch Veränderung des durch die Ladepumpe 88 erzeugten Ladestroms erreicht werden.

Durch das erfindungsgemäße Phasenregelkreissystem wird das Phasenrauschen bei einem Empfänger optimiert. Der Empfänger ist dabei sowohl zum Empfang analog modulierter als auch digital modulierter Signale einsetzbar. Das erfindungsgemäße Phasenregelkreissystem ist insbesondere für Empfänger geeignet, die zum Empfang von digitalen Fernsehsignalen eingesetzt werden. Diese digitalen Fernsehsignale können beispielsweise in einem OFDM-Multiplexverfahren digital terrestrisch in ei-nem digitalen DVB-Fernsehverteildienst ausgestrahlt werden.

Durch die Umschaltung zwischen verschiedenen Frequenzteilungsverhältnissen für analog modulierte Rundfunksignale und digital modulierte Rundfunksignale ist es möglich, bisher bereits bestehende Schaltungsbausteine, die bei den bisherigen analogen Rundfunksignalen eingesetzt wurden, schaltungstechnisch zu ergänzen, so daß sie auch für den Empfang digital modulierter Rundfunksignale, insbesondere digital modulierter Fernsehempfangssignale, einsetzbar sind.

Das Phasenrauschen des Empfängers wird durch das erfindungsgemäße Phasenregelkreissystem erheblich abgesenkt und somit die Fehlerrate bei der Decodierung des Signals vermindert.

**Patentansprüche**

1. Phasenregelkreissystem zur Abstimmung der Empfangsfrequenz eines Empfängers für digital und analog modulierte Empfangssignale mit mindestens einem spannungsgesteuerten Oszillator (29, 45) zur Erzeugung eines Oszillatorsignals zur Empfangsfrequenzabstimmung, einem ersten Frequenzteiler (71) zur Teilung der Frequenz des Oszillatorsignals auf eine Soll-Vergleichsfrequenz in Abhängigkeit von einem Empfangskanal-Auswahlsignal, einem Referenz-Oszillator (84) zur Abgabe eines Referenz-Oszillatorsignals mit einer bestimmten Referenzfrequenz, einem zweiten Frequenzteiler (81) zur Teilung der Referenzfrequenz in Abhängigkeit von einem Empfangsart-Umschaltsignal, einer Phasenvergleichsschaltung (83, 88) zum Vergleich der von den Frequenzteilern (71, 81) abgegebenen Signale zur Erzeugung einer Abstimmspannung für den spannungsgesteuerten Oszillator (29, 45), wobei die Verstärkung der Phasenvergleichsschaltung (83, 88) zur Optimierung des Phasenrauschens einstellbar ist, **dadurch gekennzeichnet, daß** das Empfangssignal durch eine Multipliziereinrichtung (27, 39) mit dem Oszillatorsignal zur Erzeugung eines Zwischenfrequenzsignals multiplizierbar ist, der Multipliziereinrichtung (27, 39) eine Erfassungsschaltung zur Erfassung des Phasenrauschens des Zwischenfrequenzsignals nachgeschaltet ist und die Verstärkung der Phasenvergleichsschaltung (83, 88) in Abhängigkeit von einem Steuersignal einstellbar ist, das von der Erfassungsschaltung zur Erfassung des Phasenrauschens erzeugt wird.

2. Phasenregelkreissystem nach Anspruch 1, **dadurch gekennzeichnet, daß** die Phasenvergleichsschaltung (83, 88) aus einem Phasenkomparator (83) und einer Ladungspumpe (88) besteht, wobei die Verstärkung der Phasenvergleichsschaltung durch einen Ladestrom einstellbar ist, der durch die Ladungspumpe (88) erzeugt wird.

3. Phasenregelkreissystem nach Anspruch 1 oder 2, **dadurch gekennzeichnet, daß** die Ladungspumpe (88) den Ladestrom in Abhängigkeit von einem Steuersignal einstellt, das von einer mit der Ladungspumpe (88) verbundenen Steuerung (89) abgegeben wird.

**4.** Phasenregelkreissystem nach einem der vorangehenden Ansprüche, **dadurch gekennzeichnet, daß** das Frequenzteilungsverhältnis des ersten Frequenzteilers (71) zwischen einer Vielzahl von Frequenzteilungsverhältnissen in Abhängigkeit von dem Empfangskanal-Auswahlsignal schaltbar ist, wobei für jeden Empfangskanal jeweils ein Frequenzteilungsverhältnis für den Empfang eines analog modulierten und eines digital modulierten Empfangssignals in einer Speichereinrichtung (73) gespeichert ist.

**5.** Phasenregelkreissystem nach einem der vorangehenden Ansprüche, **dadurch gekennzeichnet, daß** das Frequenzteilungsverhältnis des zweiten Frequenzteilers (81) zwischen einem ersten Frequenzteilungsverhältnis für ein analog moduliertes Empfangssignal und einem zweiten Frequenzteilungsverhältnis für ein digital moduliertes Empfangssignal durch eine Schalteinrichtung (79) umschaltbar ist.

**6.** Phasenregelkreissystem nach einem der vorangehenden Ansprüche, **dadurch gekennzeichnet, daß** der Referenz-Oszillator (84) ein Quarzkristall ist.

**7.** Phasenregelkreissystem nach einem der vorangehenden Ansprüche, **dadurch gekennzeichnet, daß** der erste Frequenzteiler (71) an eine Empfangskanal-Auswahleinrichtung (75) zur Erzeugung des Empfangskanal-Auswahlsignals angeschlossen ist.

**8.** Phasenregelkreissystem nach einem der vorangehenden Ansprüche, **dadurch gekennzeichnet, daß** der Multipliziereinrichtung (27, 39) eine automatische Verstärkungsregelschaltung (57) nachgeschaltet ist, die das Empfangssignal in Abhängigkeit von der Amplitude des Zwischenfrequenzsignals verstärkt.

**9.** Phasenregelkreissystem nach einem der vorangehenden Ansprüche, **dadurch gekennzeichnet, daß** die von der Phasenvergleichsschaltung erzeugte Abstimmspannung durch ein Schleifenfilter (92) gefiltert wird.

**10.** Phasenregelkreissystem nach einem der vorangehenden Ansprüche, **dadurch gekennzeichnet, daß** der Multipliziereinrichtung (27, 53) mindestens ein Signalverstärker (34, 54) und ein SAW-Bandpaßfilter (59a) nachgeschaltet ist.

**11.** Phasenregelkreissystem nach einem der vorangehenden Ansprüche, **dadurch gekennzeichnet,**

**daß** die Soll-Vergleichsfrequenz 62,5 kHz für analog modulierte Empfangssignale und 166,7 kHz oder 250 kHz für digital modulierte Empfangssignale beträgt.

**12.** Phasenregelkreissystem nach einem der vorangehenden Ansprüche, **dadurch gekennzeichnet, daß** der Referenz-Oszillator (84) ein Referenz-Oszillatorsignal mit einer Frequenz von 4 MHz erzeugt.

**13.** Phasenregelkreissystem nach einem der vorangehenden Ansprüche, **dadurch gekennzeichnet, daß** der zweite Frequenzteiler (81) zwischen einem Frequenzteilungsverhältnis von 64 für ein analog moduliertes Empfangssignal und einem Frequenzteilungsverhältnis von 24 für ein digital moduliertes Empfangssignal umschaltbar ist.

**14.** Phasenregelkreissystem nach einem der vorangehenden Ansprüche 1 bis 15, **dadurch gekennzeichnet, daß** der zweite Frequenzteiler (81) zwischen einem Frequenzteilungsverhältnis von 64 für ein analog moduliertes Empfangssignal und einem Frequenzteilungsverhältnis von 16 für ein digital moduliertes Empfangssignal umschaltbar ist.

**15.** Phasenregelkreissystem nach einem der vorangehenden Ansprüche, **dadurch gekennzeichnet, daß** eine Modulationsart-Erkennungsschaltung zur Erkennung der Modulationsart vorgesehen ist, die erkennt, ob das Empfangssignal analog oder digital moduliert ist.

**16.** Phasenregelkreissystem nach Anspruch 15, **dadurch gekennzeichnet, daß** die Modulationsart-Erkennungsschaltung die Frequenzteilungsverhältnisse der Frequenzteiler (71, 81) in Abhängigkeit davon einstellt, ob das Empfangssignal analog oder digital moduliert ist.

**Claims**

**1.** Phase locked loop system for tuning the reception frequency of a receiver for digitally and analog-modulated received signals having
at least one voltage controlled oscillator (29, 45) for producing an oscillator signal for reception frequency tuning,
a first frequency divider (71) for dividing the frequency of the oscillator signal to a nominal comparison frequency as a function of a receiving channel selection signal,
a reference oscillator (84) for emitting a reference oscillator signal at a specific reference frequency,
a second frequency divider (81) for dividing the reference frequency as a function of a reception mode switching signal,

a phase comparison circuit (83, 88) for comparing the signals emitted from the frequency dividers (71, 81) in order to produce a tuning voltage for the voltage-controlled oscillator (29, 45), with the gain of the phase comparison circuit (83, 88) being adjustable in order to optimize the phase noise, **characterized in that** the received signal can be multiplied by means of a multiplication device (27, 39) by the oscillator signal in order to produce an intermediate frequency signal, the multiplication device (27, 39) has a detection circuit connected downstream from it in order to detect the phase noise on the intermediate frequency signal, and the gain of the phase comparison circuit (83, 88) is adjustable as a function of the control signal which is produced by the detection circuit in order to detect the phase noise.

2. Phase locked loop system according to Claim 1, **characterized in that** the phase comparison circuit (83, 88) comprises a phase comparator (83) and a charge pump (88), with the gain of the phase comparison circuit being adjustable by means of a charging current which is produced by the charge pump (88).

3. Phase locked loop system according to Claim 1 or 2, **characterized in that** the charge pump (88) sets the charging current as a function of a control signal which is emitted by a controller (89) connected to the charge pump (88).

4. Phase locked loop system according to one of the preceding claims, **characterized in that** the frequency division ratio of the first frequency divider (71) can be switched between a large number of frequency division ratios as a function of the receiving channel selection signal, with a frequency division ratio for receiving an analog-modulated received signal and a digitally modulated received signal being stored for each receiving channel in a memory device (73).

5. Phase locked loop system according to one of the preceding claims, **characterized in that** the frequency division ratio of the second frequency divider (81) can be switched between a first frequency division ratio for an analog-modulated received signal and a second frequency division ratio for a digitally modulated received signal by means of a switching device (79).

6. Phase locked loop system according to one of the preceding claims, **characterized in that** the reference oscillator (84) is a quartz crystal.

7. Phase locked loop system according to one of the preceding claims, **characterized in that** the first frequency divider (71) is connected to a receiving channel selection device (75) for producing the receiving channel selection signal.

8. Phase locked loop system according to one of the preceding claims, **characterized in that** the multiplication device (27, 39) has an automatic gain control circuit (57) connected downstream from it, which amplifies the received signal as a function of the amplitude of the intermediate frequency signal.

9. Phase locked loop system according to one of the preceding claims, **characterized in that** the tuning voltage produced by the phase comparison circuit is filtered by a loop filter (92).

10. Phase locked loop system according to one of the preceding claims, **characterized in that** the multiplication device (27, 53) has at least one signal amplifier (34, 54) and one SAW bandpass filter (59a) connected downstream from it.

11. Phase locked loop system according to one of the preceding claims, **characterized in that** the nominal comparison frequency is 62.5 kHz for analog-modulated received signals, and 166.7 kHz or 250 kHz for digitally modulated received signals.

12. Phase locked loop system according to one of the preceding claims, **characterized in that** the reference oscillator (84) produces a reference oscillator signal at a frequency of 4 MHz.

13. Phase locked loop system according to one of the preceding claims, **characterized in that** the second frequency divider (81) can be switched between a frequency division ratio of 64 for an analog-modulated received signal, and a frequency division ratio of 24 for a digitally modulated received signal.

14. Phase locked loop system according to one of the preceding Claims 1 to 15 [sic], **characterized in that** the second frequency divider (81) can be switched between a frequency division ratio of 64 for an analog-modulated received signal, and a frequency division ratio of 16 for a digitally modulated received signal.

15. Phase locked loop system according to one of the preceding claims, **characterized in that** a modulation type identification circuit is provided in order to identify the modulation type and identifies whether the received signal is analog-modulated or digitally modulated.

16. Phase locked loop system according to Claim 15, **characterized in that** the modulation type identification circuit sets the frequency division ratios of the frequency dividers (71, 81) as a function of whether the received signal is analog-modulated or digitally modulated.

## Revendications

1. Système de circuit régulateur de phase destiné à syntoniser la fréquence de réception d'un récepteur pour des signaux de réception modulés numériquement ou analogiquement, comportant au moins un oscillateur (29, 45) commandé par tension destiné à produire un signal oscillant pour syntoniser la fréquence de réception, un premier diviseur de fréquence (71) destiné à diviser la fréquence du signal oscillant par une fréquence nominale de référence en fonction d'un signal de sélection du canal de réception, un oscillateur de référence (84) destiné à délivrer un signal oscillant de référence et muni d'une certaine fréquence de référence, un deuxième diviseur de fréquence (81) destiné à diviser la fréquence de référence en fonction d'un signal de commutation du type de réception, un circuit comparateur de phase (83, 88) destiné à comparer les signaux délivrés par les diviseurs de fréquence (71, 81) afin de produire une tension de syntonisation pour l'oscillateur (29, 45) commandé par tension, l'amplification du circuit comparateur de phase (83, 88) pouvant être réglée pour optimiser le bruit de phase, **caractérisé en ce que** le signal de réception peut être multiplié par le signal oscillant à l'aide d'un dispositif de multiplication (27, 39) pour produire un signal de fréquence intermédiaire, un circuit d'acquisition destiné à acquérir le bruit de phase du signal de fréquence intermédiaire est monté en aval du dispositif de multiplication (27, 39) et l'amplification du circuit comparateur de phase (83, 88) peut être réglée en fonction d'un signal de commande qui est produit par le circuit d'acquisition destiné à acquérir le bruit de phase.

2. Système de circuit régulateur de phase selon la revendication 1, **caractérisé en ce que** le circuit comparateur de phase (83, 88) est composé d'un comparateur de phase (83) et d'une pompe de charge (88), l'amplification du circuit comparateur de phase pouvant être réglée par un courant de charge qui est produit par la pompe de charge (88).

3. Système de circuit régulateur de phase selon la revendication 1 ou 2, **caractérisé en ce que** la pompe de charge (88) règle le courant de charge en fonction d'un signal de commande qui est délivré par une commande (89) liée à la pompe de charge (88).

4. Système de circuit régulateur de phase selon l'une des revendications précédentes, **caractérisé en ce que** le rapport de division de fréquence du premier diviseur de fréquence (71) peut être commuté entre un grand nombre de rapports de division de fréquence en fonction du signal de sélection du canal de réception, un rapport de division de fréquence, destiné à recevoir un signal de réception modulé numériquement et un signal de réception modulé analogiquement, étant respectivement enregistré dans une mémoire (73) pour chaque canal de réception.

5. Système de circuit régulateur de phase selon l'une des revendications précédentes, **caractérisé en ce que** le rapport de division de fréquence du deuxième diviseur de fréquence (81) peut être commuté par un dispositif de commutation (79) entre un premier rapport de division de fréquence pour un signal de réception modulé analogiquement et un deuxième rapport de division de fréquence pour un signal de réception modulé numériquement.

6. Système de circuit régulateur de phase selon l'une des revendications précédentes, **caractérisé en ce que** l'oscillateur de référence (84) est un cristal de quartz.

7. Système de circuit régulateur de phase selon l'une des revendications précédentes, **caractérisé en ce que** le premier diviseur de fréquence (71) est raccordé à un dispositif de sélection du canal de réception (75) destinée à produire le signal de sélection du canal de réception.

8. Système de circuit régulateur de phase selon l'une des revendications précédentes, **caractérisé en ce qu'**en aval de du dispositif de multiplication (27, 39) est monté un circuit de réglage de l'amplification (57) automatique qui amplifie le signal de réception en fonction de l'amplitude du signal de fréquence intermédiaire.

9. Système de circuit régulateur de phase selon l'une des revendications précédentes, **caractérisé en ce que** la tension de syntonisation produite par le circuit comparateur de phase est filtrée par un filtre de boucle (92).

10. Système de circuit régulateur de phase selon l'une des revendications précédentes, **caractérisé en ce qu'**au moins un amplificateur de signal (34, 54) et un filtre passe-bande d'onde superficielle de signal (59a) sont montés en aval du dispositif de multiplication (27, 53).

11. Système de circuit régulateur de phase selon l'une des revendications précédentes, **caractérisé en ce**

**que** la fréquence nominale de référence est de 62,5 kHz pour des signaux de réception modulés analogiquement et de 166,7 kHz ou de 250 kHz pour des signaux de réceptions modulés numériquement.

12. Système de circuit régulateur de phase selon l'une des revendications précédentes, **caractérisé en ce que** l'oscillateur de référence (84) produit un signal oscillant de référence d'une fréquence de 4 MHz.

13. Système de circuit régulateur de phase selon l'une des revendications précédentes, **caractérisé en ce que** le deuxième diviseur de fréquence (81) peut être commuté entre un rapport de division de fréquence de 64 pour un signal de réception modulé analogiquement et un rapport de division de fréquence de 24 pour un signal de réception modulé numériquement.

14. Système de circuit régulateur de phase selon l'une des revendications précédentes 1 à 1[2], **caractérisé en ce que** le deuxième diviseur de fréquence (81) peut être commuté entre un rapport de division de fréquence de 64 pour un signal de réception modulé analogiquement et un rapport de division de fréquence de 16 pour un signal de réception modulé numériquement.

15. Système de circuit régulateur de phase selon l'une des revendications précédentes, **caractérisé en ce que** l'on prévoit un circuit de reconnaissance du type de modulation, destiné à reconnaître le type de modulation, qui reconnaît si le signal de réception est modulé numériquement ou analogiquement.

16. Système de circuit régulateur de phase selon la revendication 15, **caractérisé en ce que** le circuit de reconnaissance de type de modulation règle les rapports de division de fréquence pour les diviseurs de fréquence (71, 81) selon que le signal de réception est modulé numériquement ou analogiquement.

FIG 1

# FIG 2

dB/Hz

0

(b)

-30

(c)

-50

(a)

-120

$\omega_{N1}$ $\omega_{N2}$     10 MHz     $f_{OFFSET}$

# FIG 3

dB/Hz

(a)

(b)

$\omega_N$     10 MHz     $f_{OFFSET}$

## FIG 4A

$N_r = 64$

## FIG 4B

$N_r = 16$

## FIG 4C

$N_r = 64$

## FIG 4D

$N_r = 16$

## FIG 4E

$N_r = 64$

## FIG 4F

$N_r = 16$

## FIG 5A

$N_r = 64$

## FIG 5B

$N_r = 16$

## FIG 5C

$N_r = 64$

## FIG 5D

$N_r = 16$

## FIG 6A

## FIG 6B

# FIG 7